(19)

**Europäisches Patentamt**
**European Patent Office**
**Office européen des brevets**

(11) **EP 4 311 864 A1**

(12) **EUROPEAN PATENT APPLICATION**

(43) Date of publication:
**31.01.2024 Bulletin 2024/05**

(51) International Patent Classification (IPC):
**C23C 14/14** (2006.01)     **C23C 14/34** (2006.01)
**C23C 14/35** (2006.01)     **C23C 14/54** (2006.01)
**C23C 30/00** (2006.01)

(21) Application number: **22187450.6**

(22) Date of filing: **28.07.2022**

(52) Cooperative Patent Classification (CPC):
**C23C 14/14; C23C 14/3485; C23C 14/352;**
**C23C 14/541; C23C 14/548; C23C 30/00**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicants:
• **Österreichische Akademie der Wissenschaften**
  **1010 Wien (AT)**
• **Montanuniversität Leoben**
  **8700 Leoben (AT)**

(72) Inventors:
• **Eckert, Jürgen**
  **8700 Leoben (AT)**

• **Xia, Ao**
  **1100 Wien (AT)**
• **Sopu, Daniel**
  **8700 Leoben (AT)**
• **Putz, Barbara**
  **8700 Leoben (AT)**
• **Spieckermann, Florian**
  **1230 Wien (AT)**
• **Mitterer, Christian**
  **8700 Leoben (AT)**
• **Mühlbacher, Marlene**
  **9500 Villach (AT)**

(74) Representative: **Patentanwaltskanzlei**
**Matschnig & Forsthuber OG**
**Biberstraße 22**
**Postfach 36**
**1010 Wien (AT)**

(54) **WZRB THIN FILM METALLIC GLASSES, MANUFACTURE AND USES THEREOF**

(57)     The present invention relates to a scratch-resistant article comprising:
a substrate, and
an amorphous WZrB thin film deposited on the substrate by magnetron sputter deposition (MSD), wherein the amorphous WZrB thin film is defined by the following formula:

$$W_{(100-a-b-x)}Zr_aB_b$$

with 1 at% $\leq$ a $\leq$ 25 at%; 1 at% $\leq$ b $\leq$ 35 at%; wherein 9 at% $\leq$ a + b $\leq$ 60 at%; and the balance being tungsten and unavoidable impurities x, wherein the unavoidable impurities x may be present in the amorphous WZrB thin film in an amount of up to 4 at%; wherein the amorphous WZrB thin film has a hardness **H** of 19 GPa or more, preferably of 20 GPa or more, and a Young's modulus **E** in a range from 150 GPa to 300 GPa, and the layer thickness of the amorphous WZrB thin film is in a range from 0.2 $\mu$m to 20.0 $\mu$m. The present invention also relates to the uses of the scratch-resistant article as well as to a method for producing scratch-resistant surfaces of articles.

Fig. 4

**Description**

The present invention relates to a scratch-resistant article and uses thereof as well as to a method for producing scratch-resistant surfaces of articles.

Metallic glasses (MGs) represent a relatively new material class, which was introduced in the 1960s. Different to conventional crystalline alloys design, which have atoms arranged in a regular crystalline structure with long range translation symmetry, atoms distributed in MGs are characterized by their non-crystalline non-periodic short and medium-range order, resembling frozen in liquid structures. This amorphous arrangement of atoms results in attractive properties, such as high wear resistance, high hardness, high yield strength, superior elastic limit and high corrosion resistance, which are promising for high temperature applications as protective coatings for cutting tools, in microelectronics or sporting and biomedical instruments. Especially, refractory MGs are promising for ultra-high temperature applications due to their high melting temperatures ($T_m$) of up to 3400 °C and high temperature strengths of the individual elements.

MGs are usually fabricated either in form of thin ribbons by rapid quenching from the melt or, in case of easy glass-forming systems in bulk form, with the smallest sample dimensions around 1 mm.

A relatively new approach to synthesize MGs is using the physical vapor deposition route to create thin film metallic glasses (TFMGs). Novel MGs, termed "ultrastable glasses", exhibiting high glass transition temperatures ($T_g$) have been prepared via vapor deposition routes, and were characterized concerning their remarkably high thermodynamic and kinetic stabilities.

There is a constant need for alternative or improved tribological coating materials, which improve the performance and wear resistance of tools and other industrially relevant instruments and devices. Furthermore, as space missions and space mining becomes economically feasible in the near future, there is an increasing demand for vacuum stable materials with good mechanical and tribological properties during space operation.

The object of the present invention is to provide a scratch-resistant coating on a substrate, wherein the substrate may be selected from a great variety of substrate materials, to obtain a scratch-resistant article having excellent mechanical and tribological properties and being useful for many different applications. Moreover, it is an object to provide a novel scratch-resistant coating on a substrate, having a wear-resistance comparable to industrially relevant tribological coatings such as TiN, CrAlN, and TiAlN, wherein the novel coating should represent a beneficial alternative to the known tribological coatings by showing similar or better wear resistance not only at low temperatures or room temperature, but also at high temperatures, thus, operating over a wide range of temperatures. It is especially desirable and, thus, a specific object of the present invention that the scratch-resistant coating should have stable mechanical and tribological properties at the harsh space conditions, which include vacuum stability at low temperature environments.

The above-mentioned objects are met by the present invention. In a first aspect, the present invention relates to a scratch-resistant article, comprising:

a substrate, and
an amorphous WZrB (W = tungsten; Zr = zirconium; B = boron) thin film deposited on the substrate by magnetron sputter deposition (MSD), wherein the amorphous WZrB thin film is defined by the following formula:

$$W_{(100-a-b-x)}Zr_aB_b$$

with
1 at% $\leq$ a $\leq$ 25 at%;
1 at% $\leq$ b $\leq$ 35 at%;
wherein 9 at% $\leq$ a + b $\leq$ 60 at%;
and the balance being tungsten and unavoidable impurities x, wherein the unavoidable impurities x may be present in the amorphous WZrB thin film in an amount of up to 4 at%; wherein the amorphous WZrB thin film has a hardness H of 19 GPa or more, preferably of 20 GPa or more, and a Young's modulus E in a range from 150 GPa to 300 GPa, and the layer thickness of the amorphous WZrB thin film is in a range from 0.2 $\mu$m to 20.0 $\mu$m. Accordingly, the formula expression "$W_{(100-a-b-x)}Zr_aB_b$" signifies that the sum of W, Zr, B and, if present, unavoidable impurities, is 100 at%, wherein the values for a (Zr), b (B) and x (unavoidable impurities) are as defined herein and the balance being W.

The invention is based on the surprising finding that the amorphous WZrB thin films (herein also referred to as WZrB thin film metallic glasses (WZrB-TFMGs)) deposited on the substrates show excellent mechanical and tribological properties, also at high temperature wear application. This beneficial technical effect is demonstrated and evidenced by the experimental data given in the experimental chapter below. The results show that a stable, oxidation and wear resistant amorphous WZrB thin film was formed on multiple industrially relevant substrates. Specifically, it has been demonstrated that the wear resistance of the amorphous WZrB thin film deposited on a substrate is comparable to industrially relevant coatings such as TiN, CrAlN and TiAlN. Thus, the amorphous WZrB thin film represents a beneficial alternative to e.g. diamond like-carbon (DLC), as the invention is also applicable in elevated/high temperature wear applications and tribological environments, e.g. aeronautical applications, engines, power generation, transport, packaging industry applications, and processing industries. Furthermore, the H/E-ratio remained constant for the magnetron-sputtered WZrB thin film metallic glasses (WZrB-TFMGs) on cemented carbide substrates with increasing vacuum annealing temperature. The tribological tests revealed an oxidation and wear resistant thin film material with a coefficient of friction similar to conventional ceramic protective coatings. The results show that good mechanical stability can be expected up to a glass transition temperature $T_g$ of 800 °C. The present invention opens a wide range of applications, including applications in space technology requiring vacuum stability at low temperature environments. In addition, MSD allows the on-site fabrication of the thin film on the substrate during a space mining mission.

The vacuum stability of WZrB thin film metallic glasses as disclosed in the present invention compared to conventional tribological coatings is explained by the oxide formation of the latter during wear while the former do not form oxides which act as a lubricant to reduce wear. However, in vacuum, no oxygen is present to form oxides. Thus, the wear application of conventional tribological coatings is not suitable in vacuum atmosphere. Therefore, the WZrB thin film metallic glasses applied in the present invention are suitable for vacuum and low temperature applications, since the mechanical properties of metallic glasses remain steady from -273 °C up to 85% $T_g$.

Due to the amorphous structure of the WZrB thin film, there are hardly any grain boundaries. This favors a low roughness, which is preferably less than 1 $\mu$m, and reduces material wear due to friction. Furthermore, due to the amorphous structure of the WZrB thin film, it can be deposited onto different substrates without the structure of the substrate influencing the properties of the amorphous structure of the WZrB thin film.

As a practical matter, unavoidable impurities x may be found in the WZrB thin films of a scratch-resistant article according to the invention. The unavoidable impurities x that may be present in the WZrB thin film do not include the listed elements of W, Zr, and B. Unavoidable impurities may include impurities that cannot be controlled, or controlled with difficulty, during the MSD-deposition of the WZrB thin film on the substrate. These can come from their presence in raw materials used and also from the manufacturing process described in this disclosure. As mentioned above, the unavoidable impurities x may be present in the WZrB thin film in an amount of up to 4 at%, preferably in an amount of up to 1 at%. These unavoidable impurities present in the WZrB thin film may include O (oxygen), H (hydrogen), C (carbon) and N (nitrogen), wherein: an unavoidable impurity may be O, wherein O may be present up to 1 at%. An unavoidable impurity may be H, wherein H may be present up to 1 at%. An unavoidable impurity may be C, wherein C may be present up to 1 at%. An unavoidable impurity may be N, wherein N may be present up to 1 at%.

As per the invention, the WZrB thin film of the scratch-resistant article is an amorphous WZrB thin film. It is within the knowledge and common skill of those skilled in the art to determine the microstructure of thin films deposited on substrates via MSD. The microstructure may be determined e.g. by X-ray diffraction or transmission electron microscopy (TEM) and respective image analysis of the obtained images, as described in the experimental chapter below.

In view of the teachings of the present disclosure, a person skilled in the art will be readily able, based on his or her expertise and on basis of simple routine tests, respectively, to select the respective MSD-parameters and respective substrate such that a WZrB thin film as described herein and defined in the appended claims is deposited on the respective substrate.

The present invention relates to a scratch-resistant article and methods for producing scratch-resistant surfaces of articles. As will be appreciated by those skilled in the art, the term "scratch" refers to physical deformations of an article's surface resulting from mechanical, physical or chemical (e.g. oxidation) abrasion. "Scratch resistance" is a measure of a material's ability to resist damage caused by mechanical, physical or chemical (e.g. oxidation) stress that can lead to trenches or abrasions in the material.

The hardness H and Young's (elastic) modulus E of the deposited WZrB thin films may be measured and determined with any means known to those skilled in the art, e.g. by means of nanoindentation as described in the experimental chapter below.

In preferred embodiments, the **H**/**E**-ratio of the amorphous WZrB thin film is in a range from 0.05 to 0.13.

In preferred embodiments, the composition of the amorphous WZrB thin film of the scratch-resistant article being defined by the above-described formula $W_{(100-a-b-x)}Zr_aB_b$ may be as follows: 1 at% $\leq$ a $\leq$ 18 at%, 1 at% $\leq$ b $\leq$ 11 at%, 9 at% $\leq$ a + b $\leq$ 21 at%, unavoidable impurities x $\leq$ 4 at%, preferably unavoidable impurities x $\leq$ 1 at%, and the balance being tungsten; wherein the amorphous WZrB thin film has a hardness **H** in a range from 20 GPa to 21 GPa and a Young's modulus **E** in a range from 175 GPa to 217 GPa, wherein the **H**/**E** ratio is in a range from 0.09 to 0.12.

In preferred embodiments, the composition of the amorphous WZrB thin film of the scratch-resistant article being defined by the above-described formula $W_{(100-a-b-x)}Zr_aB_b$ is optimized and may be as follows: 1 at% $\leq$ a $\leq$ 3 at%; 7 at% $\leq$ b $\leq$ 9 at%; 9 at% $\leq$ a + b $\leq$ 11 at%; unavoidable impurities x $\leq$ 4 at%, preferably unavoidable impurities x $\leq$ 1 at%; and the balance being tungsten. Surprisingly, a WZrB thin film of this preferred embodiment being deposited on a substrate was found to be particularly wear-resistant and to have particularly good tribological properties.

As per the experimental data, the thin film was found to be amorphous up to 91 at% W content in the thin film, while the film adhesion on steel and silicon substrate remained excellent. Furthermore, room temperature (RT) wear resistance was found to be in the range of established protective coatings while the high temperature (HT) wear resistance was found to be superior to the established ones.

The above-described optimized compositions of these preferred embodiments contains a high amount of tungsten. In contrast to these tungsten-rich WZrB-coatings of the invention, pure tungsten coatings have different properties. Pure tungsten coatings are very hard (having a hardness H of approximately 32 GPa) due to the high layer residual stresses, but also have a very high Young's modulus of approx. 410 GPa. As a result, the H/E ratio and thus the toughness (elastic strain to fracture) is very low. With increasing layer thickness, the adhesion of pure tungsten coatings becomes poorer and the layer will detach from the substrate. In addition, pure tungsten coatings oxidize in the atmosphere. The WZrB thin films of the scratch-resistant articles according to the invention, in particular the optimized embodiments, do not have these disadvantages, but show improved toughness and adhesion.

According to a further preferred embodiment of the present invention, the amorphous WZrB thin film has a hardness **H** of 21 GPa and a Young's modulus **E** of 175 GPa, wherein the **H/E** ratio is 0.12.

Preferably, the amorphous WZrB thin film has a surface roughness of < 0.1 $\mu$m. The surface roughness of the deposited WZrB thin films may be measured and determined with any means known to those skilled in the art, e.g. by laser scanning confocal microscopy as described in the experimental chapter below.

The substrate of the scratch-resistant article according to the invention may be based on any substrate material that is suitable for undergoing a coating procedure by means of MSD. Advantageously, the substrate/substrate material is industrially relevant. Preferably, but not restricted thereto, the substrate and/or substrate material is selected from the group consisting of: semiconductors (e.g. Si, Ga, ZnTe, CdS, GaN, SiC, Ge), NaCl, cemented carbides, glass, ceramics, polymers, steels and metallic alloys.

In certain embodiments, the scratch-resistant article further comprises at least one intermediate layer as an undercoat, which is deposited on the substrate, wherein the amorphous WZrB thin film is deposited on the intermediate layer. The intermediate layer may be deposited on the substrate by magnetron sputter deposition and may be composed of Ti, TiO, and/or TiN. The intermediate layer has the beneficial effect to improve film adhesion. The intermediate layer may be in the form of a single layer or of a multilayer, wherein the interlayer thickness is up to a few hundred nanometers.

Preferably, the amorphous WZrB thin film has a residual crystallinity of at most 8 at%.

In another aspect, the present invention relates to a method for producing scratch-resistant surfaces of articles, comprising the steps of:

(a) providing a substrate, in a sputtering apparatus, wherein the sputtering apparatus comprises a tungsten target and a Zr/B alloy target consisting of Zr and B in a mixing ratio Zr:B from 30:70 to 37:63 at%;

b) releasing sputtered particles using a magnetron sputter deposition (MSD) process under process gas atmosphere at a process pressure in the range from 0.3 Pa to 0.6 Pa and at a cooling rate of $10^{12}$ Ks$^{-1}$ to $10^{14}$ Ks$^{-1}$, at a power in the range of 0.22 to 2.5 W/cm$^2$ per target surface area of the tungsten target and a power in the range of 0.84 to 0.91 W/cm$^2$ per target surface area of the Zr/B alloy target, wherein the power ratio of the tungsten target: the Zr/B alloy target is ranging from 18:74 to 200:68.

c) controlling the magnetron sputter deposition (MSD) process such that amorphous WZrB is deposited as a thin film having a layer thickness in a range of 0.2 $\mu$m to 20.0 $\mu$m on the substrate.

In view of the teachings of the present disclosure, a person skilled in the art will be readily able, based on his or her expertise and on basis of simple routine tests, respectively, to select the respective MSD-parameters and respective substrate such that a WZrB thin film as described herein and defined in the appended claims is deposited on the respective substrate.

Suitable targets for magnetron sputter deposition as used in the present invention and defined herein may be obtained from many manufacturers, e.g. from Kurt J. Lesker Company Ltd. and Plansee Composite Materials GmbH

Advantageously, the substrates may be sputter-cleaned in pure Ar for, e.g. 2 min, to ensure removal of impurities on the substrate surface prior to depositing the amorphous WZrB thin film on the substrate surface. Additionally or alternatively, the substrate may be plasma-etched in order to enhance the adhesion of the sputtered thin film to the substrate surface.

The process gas may be any gas that is suitable for being used in a magnetron sputter deposition (MSD) process as described herein, and, preferably, is selected from Ar (argon), Ne neon), Kr (krypton) or Xe (xenon). Most preferably, Ar is used as process gas.

Magnetron sputter deposition (MSD) and sputtering apparatus for performing MSD are well known to those skilled in the art. The principle of MSD and sputtering apparatus suitable for MSD in relation to the present invention is briefly described in the following. In the method of the present invention, a sputtering apparatus with mounted targets as described herein is provided. The sputtering apparatus has a processing chamber which is loaded with the substrate(s) being made of a material and having a size and form depending on its intended use and application. The process chamber is evacuated to vacuum level, preferably below $6 \times 10^{-4}$ Pa. The processing chamber comprises the herein defined targets with the materials to be sputtered. In case of the invention, a tungsten target and an Zr/B alloy target consisting of Zr and B in a mixing ratio Zr : B from 30 : 70 to 37 : 63 at% are used. The substrates may be sputter-cleaned in pure Ar for, e.g. 2 min, to ensure removal of impurities on the substrate surface prior to depositing the amorphous WZrB thin film on the substrate surface via MSD. For MSD, process gas, typically argon, is introduced into the processing chamber, until a processing pressure ranging from 0.3 Pa to 0.6 Pa is reached therein. A DC power is applied to the targets to ignite a plasma in the processing chamber. Thereby, a sputtering process is initiated, which results in the deposition of material from the targets onto the substrate. The cooling rate and the applied power density per target surface area (in W/cm$^2$) are as defined in the present disclosure. The MSD process is controlled in a manner such that amorphous WZrB is deposited as a thin film having a layer thickness in a range of 0.2 $\mu$m to 20.0 $\mu$m on the substrate.

Preferably, the residual oxygen concentration in the process chamber of the magnetron sputter deposition (MSD)-apparatus is at most 1 at%.

Preferably, the process pressure in the magnetron sputter deposition (MSD) process applied in the method of the invention is about 0.4 Pa. Unless specifically stated or obvious from context, as used herein, the term "about" is understood as within a range of normal tolerance in the art. Specifically, as regards the process pressure, the term "about" can be understood as a deviation of +/- 0.04 Pa from a given value.

In certain embodiments of the method of the present invention, in order to modify the WZrB thin film composition, the sputtering apparatus may further comprise a Zr target, wherein during steps b) and c) sputtered particles are released from the Zr target at a power in the range of 0.84 to 0.91 W/cm$^2$ per target surface area of the Zr target. This enables to obtain a steady plasma above the Zr target, which helps to ignite the plasma for the clean etching process of the substrate material.

In certain embodiments of the method of the present invention, in the magnetron sputter deposition (MSD) process, pulsing is applied on the tungsten target and the Zr/B alloy target in an asymmetric bipolar mode at a frequency set at about 50 KHz +/- 2 KHz and a reverse time set at about 0.5 $\mu$s +/- 0.05. By applying a pulse on the target, W and Zr content can be increased while B is decreased in the thin film. Therefore, pulsing was found to be a method to adjust the chemical composition of the WZrB thin film and thus influencing the tribological and mechanical properties thereof.

In further embodiments of the method of the present invention, the deposition rate in the magnetron sputter process may be between 16 and 40 nm/min.

In another aspect, the present invention relates to a scratch-resistant article obtained by the method for producing scratch-resistant surfaces of articles as described above and herein. The features and properties of the scratch-resistant article are as described and defined in the present disclosure and appended product claims.

In another aspect, the present invention relates to the use of a scratch-resistant article of the invention and as described and defined herein:

as cutting parts for machining tools,

as components in microelectronic devices, sports articles, biomedical devices, vehicles, aircraft, ships, watch cases, watch parts, and microelectromechanical systems (MEMS),

as components of devices and systems for space technology, and

as a primed base support for a protective coating, wherein the WZrB thin film separates the protective coating from the substrate and acts as an adhesive buffer layer for the protective coating.

In specific embodiments, the scratch-resistant articles of the invention are used as cutting parts for machining tools, e.g. lathe tools, saws, drills, milling tools, reamers, blades and the like. In these embodiments, preferably steels, cemented carbides, metallic alloys, silicon and polymers are used as the substrate.

In specific embodiments, the scratch-resistant articles of the invention are used as components in microelectronic devices. In these embodiments, preferably silicon, metal oxides, polymers, and metal nitrides are used as the substrate. For example, the deposited WZrB-thin films may be useful as bounding and thermal diffusion layers with high electrical resistance in the semiconductor industry. The reason for the low diffusion lies in the WZrB thin film's amorphous coating structure, which hinders the atom mobility.

In specific embodiments, the scratch-resistant articles of the invention are used as components in sport articles.

For example, they may be advantageously used as components of racket sports articles and of golf equipment, wherein the use allows for the quick storage and release of the elastic energy due to the good ductility and high hardness of the WZrB thin film.

In specific embodiments, the scratch-resistant articles of the invention are used as components in biomedical devices. In these embodiments, preferably polymers, ceramics, and metals (Ti) are used as the substrate. For example, they may be advantageously used as a medical implant material such as dental and hip implant material, because amorphous materials, which according to the present invention is the WZrB thin film, do not corrode in the human body.

In specific embodiments, the scratch-resistant articles of the invention are used as components in the vehicle/automotive industry, including, but not limited to, components of vehicles of all kind such as land, and rail vehicles, construction vehicles and agricultural vehicles, aircraft, ships, etc. For example, the WZrB thin film of the scratch-resistant articles of the invention imparts superior hardness and elasticity to the surfaces of vehicle components, while its amorphous structure enhances the corrosion resistance of the coating and therefore protects the underlying bulk substrate.

In specific embodiments, the scratch-resistant articles of the invention are used as watch cases and watch parts such as microactuators, gearwheels, and components of the aforementioned. The superior wear resistance of the WZrB thin film of the scratch-resistant articles can be used as a new high tech material in watches, and, thus, can be an outstanding selling point in the traditional watch industry. It can be applied on small watch components such as gearwheels to reduce friction and therefore increase service interval and lifetime.

In specific embodiments, the scratch-resistant articles of the invention are used as components in microelectromechanical systems (MEMS). For example, the WZrB thin films described herein can be coated on small moving parts of sensors and sensor systems and other MEMS applications known to those in the art; e.g. the WZrB thin films may be coated on inertial measurement units, accelerometers, pressure sensors, actuators, optical switches, transducers etc., thereby reducing the wear rate and thus increasing accuracy and lifetime of MEMS.

In specific embodiments, the scratch-resistant articles of the invention are used as components of devices and systems for space technology. As mentioned above, the present invention is particularly useful in applications relating to space technology requiring vacuum stability at low temperature environments down to - 200 °C. Tungsten is very resistant to solar winds. For example, the scratch-resistant articles of the invention find application as external and internal components of, e.g., artificial satellites of all kinds, solar modules, space vehicles and space crafts, space probes, and space stations, such as structural components, claddings, casings, covers, and housings of the aforementioned. The present invention is also advantageously used in components of devices, tools, sampling devices/tools etc. used in space. In addition, the method of the present invention allows the on-site fabrication of scratch-resistant WZrB thin films on different substrates during a space mining mission. Once energy is available to power a MSD process, WZrB thin films can be deposited during the mission using the perfect vacuum available in space.

In specific embodiments, the scratch-resistant articles of the invention are used as a primed base support for a protective coating, wherein the WZrB thin film separates the protective coating from the substrate and acts as an adhesive buffer layer for the protective coating. Tungsten-based TFMGs containing cheaper substitute elements than Re or Ru would represent a cost-efficient alternative for industrial applications as an adhesive buffer layer, which is needed for better adhesion of the protective coating. For example, the problem of the deposition of pure tungsten as a protective layer on a substrate is that such pure tungsten layer adheres poorly to the substrate surface, due to poor surface bonding (roughness, mismatch) between substrate material and tungsten atoms. In most cases, this leads to lattice mismatch between substrate atoms and the tungsten lattice, resulting in increased (compressive) residual stress. The high residual stresses cause the layer to flake off and thus no longer adhere to the substrate. To avoid this problem, a very thin buffer layer, which is a WZrB thin film as described herein with the present invention, is first deposited on the substrate and the protective layer is then deposited on the buffer layer. Using a WZrB thin film as described herein has the advantage that it is scratch-resistant and amorphous, i.e. it has no grain boundaries and therefore has a very smooth surface to which e.g. tungsten atoms can adhere very well due to adhesion forces, compared to an uncoated substrate surface.

In another aspect, the present invention relates to an amorphous WZrB thin film as described in this disclosure, in particular to an amorphous WZrB thin film as defined in any one of appended claims 1 to 6, and 9. In yet another aspect, the present invention relates to an amorphous WZrB thin film obtained by a method according to the invention and as described in this disclosure, in particular to an amorphous WZrB thin film obtained by a method according to any one of appended claims 10 to 13.

The present invention is further demonstrated and illustrated by the following examples, yet without being restricted thereto. The examples are further illustrated by means of figures and drawings, which show:

Figure 1     X-ray diffractograms obtained in grazing incidence configuration of WZrB thin films deposited on Si substrates using different W target powers. Amorphous patterns are measured for WZrB-TFMGs containing between 37 and 90 at% W. The $W_{90}Zr_2B_8$ alloy chosen for further analysis is framed.

Figure 2    a) High resolution transmission electron microscopy (HR-TEM) cross-section of the $W_{90}Zr_2B_8$ film on Si with the corresponding selected area electron diffraction (SAED) pattern of the film. b) Scanning electron microscopy (SEM) cross section image of the $W_{90}Zr_2B_8$ on Si substrate. The vein patterns visible on the cross section is a typical fracture feature of ductile MGs after being exposed to stressed-induced fracturing.

Figure 3    Glass transition and crystallization behavior of MSD $W_{90}Zr_2B_8$ thin films measured at heating rates of 20 K/min. Enthalpy of relaxation is shaded between 573 K and 1073 K.

Figure 4    a) Hardness **H** and Young's modulus **E** of sputter deposited WZrB thin films on Si substrate. b) Hardness and Young's modulus of as-deposited $W_{90}Zr_2B_8$ TFMG on Si, high-speed steel (HSS) in ambient air annealed, cemented carbide (CC) and vacuum annealed CC substrates at 673 K, 773 K and 873 K.

Figure 5    a) Coefficient of friction (COF) and b) Wear depth of $W_{90}Zr_2B_8$ thin films deposited on high-speed steel (HSS) obtained by pin-on-disk test at RT, 573 K and 973 K using $Al_2O_3$ counterparts. Lower COF and higher wear were measured for TFMGs tested at 973 K.

Figure 6    3D optical profilometer images of $W_{90}Zr_2B_8$ TFMG wear tracks after tribological testing in ambient air and at different temperatures.

## EXPERIMENTAL DATA and EXAMPLES

### 1. Materials and Methods

#### 1.1 Coating of substrates with WZrB thin films by magnetron sputter deposition

WZrB thin films were sputter-deposited on single-crystalline p-doped (B) Si (100) (21 mm × 7 mm × 325 $\mu$m), NaCl (10 mm × 10 mm × 2 mm), mirror polished high-speed steel disks (HSS, DIN 1.3343, AISI M2, voestalpine Böhler Edelstahl, Austria) (90 mm thick) and 5 mm thick cemented carbide samples (CC 92 wt% WC, 6 wt% Co and 2 wt% mixed carbides, pressed and sintered to SNUN 120412 geometry according to ISO 1832). 2-inch-diameter W, $ZrB_2$ and Zr targets (Plansee Composite Materials GmbH, Germany) were confocally arranged (120° in between) in the vacuum chamber. All substrates, except NaCl, were ultrasonically cleaned in an ethanol bath and subsequently placed on a grounded rotatable substrate holder at a distance of approximately 45-55 mm to the targets in a custom-built DC magnetron sputter deposition system. The chamber was evacuated to a base pressure below $6 \times 10^{-4}$ Pa. Prior to deposition, the substrates were sputter-cleaned in pure Ar for 2 min to ensure removal of impurities on the substrate surface. For film deposition, the Ar pressure was held constant at 0.4 Pa; a constant DC power of 0.88 W/cm$^2$ was applied on the $ZrB_2$ target, while the power on the W target was varied from 0.22 W/cm$^2$ to 2.47 W/cm$^2$. To modify the thin film composition, either a third Zr target was ignited (power on the Zr target was 0.22 W/cm$^2$) or pulsing was applied on the W and $ZrB_2$ targets in the asymmetric bipolar mode with the frequency set at 50 kHz and the reverse time set at 0.5 $\mu$s. The deposition rate was calculated, based on film thickness measurements and deposition time, to be between 16 and 40 nm/min. Film with thickness of around 1.6 $\mu$m were synthesized on Si, NaCl and CC substrates, while 3 $\mu$m thick films were deposited on HSS for the subsequent tribological testing.

The following Table 1 summarizes the tested WZrB-TFMGs that were produced and subsequently characterized.

*Table 1*

| WZrB-TFMG Sample No | thin film composition | substrate | Power on W-target [W/cm2] | Third target and/or pulsing applied | |
|---|---|---|---|---|---|
| 1 | $W_{27}Zr_{40}B_{33}$ | Si | 0.22 | Third target (0.22 W/cm$^2$) | Comparative |
| 2 | $W_{37}Zr_{26}B_{37}$ | Si | 0.23 | - | Comparative |
| 3 | $W_{63}Zr_6B_{31}$ | Si | 1.05 | pulsing | According to invention |
| 4 | $W_{63}Zr_{15}B_{22}$ | Si/NaCl | 0.44 | - | According to invention |

(continued)

| WZrB-TFMG Sample No | thin film composition | substrate | Power on W-target [W/cm2] | Third target and/or pulsing applied | |
|---|---|---|---|---|---|
| 5 | $W_{72}Zr_4B_{24}$ | Si | 1.05 | - | According to invention |
| 6 | $W_{80}Zr_{18}B_2$ | Si | 0.89 | Third target (0.22 W/cm$^2$) | According to invention |
| 7 | $W_{82}Zr_{10}B_8$ | Si | 1.23 | pulsing | According to invention |
| 8 | $W_{85}Zr_4B_{11}$ | Si | 0.89 | - | According to invention |
| 9 | $W_{90}Zr_2B_8$ | Si/CC /HSS | 1.54 | - | According to invention |

**1.2 Characterization of deposited WZrB thin films by electron microscopy**

The cross-section images of WZrB thin film synthesized on Si (see chapter 1.1) were characterized with a LEO1525 scanning electron microscope (SEM). The chemical composition of the thin films was measured by means of an energy dispersive X-ray spectroscopy (EDX, Bruker XFlash 6-60) unit attached to the SEM. The microstructure of the films was investigated by X-ray diffraction (XRD) using a Bruker-AXS D8 Advance diffractometer equipped with Cu-$K_\alpha$ ($\lambda$ = 1.5418 Å) radiation and parallel optics operating at 40 kV and 40 mA . The samples were scanned in the range from 20° to 80° with a resolution of 0.02° per step for step time of 1 s/step at a glancing incidence of 2°. To confirm the structure of the deposited films, the $W_{90}Zr_2B_8$ sample was investigated by transmission electron microscopy (TEM) using a JEOL 2200 FS TEM operated at an acceleration voltage of 200 kV. Cross-sectional TEM samples were conventionally fabricated from the $W_{90}Zr_2B_8$ thin films deposited on Si substrates using a tripod polisher followed by a final thinning step using a precision ion polishing system (Gatan PIPS II).

**1.3 Characterization of deposited WZrB thin films by differential scanning calorimetry**

The glassy nature and the heat flow of the as-deposited $W_{90}Zr_2B_8$ thin films on NaCl (see chapter 1.1) were evaluated using differential scanning calorimetry (DSC, NETZSCH DSC 404 F1 Pegasus). NaCl was dissolved in ethanol and the free-standing films were floated, transferred to $Al_2O_3$ crucibles and vacuum dried in the DSC chamber at room temperature (RT). Subsequently, high purity Ar with a flow rate of 20 ml/min was used to purge the DSC chamber to prevent the samples from oxidation. The dynamic heating rate was set to 20 K/min to analyze the $T_g$ and crystallization behaviour of the specimens. No baseline subtraction was performed in order to avoid artefacts.

**1.4 Characterization of deposited WZrB thin films by nanoindentation**

$W_{90}Zr_2B_8$ samples deposited on CC substrates (see chapter 1.1) were vacuum annealed in a Xerion Xtube vaccuum chamber below $8 \times 10^{-4}$ Pa for 1 h at 673, 773 and 873 K, respectively, for subsequent nanoindentation. The heating rate was set at 283 K/min.

The hardness and Young's modulus of the films were measured by means of nanoindentation using a TS 77 Select Bruker nanoindenter. A well-calibrated Berkovich tip was used to indent the top surface of the films. At least 50 indents between 100 $\mu$N and 10.000 $\mu$N (displacement range 10 nm and 180 nm) were taken on fused silica, which was used for calibration. By using the Hertzian theory and a purely elastic indent (the 100 $\mu$N indent), the tip radius was estimated to be 200 nm. Indents ($5 \times 5$ matrix with 10 $\mu$m spacing between indents, equal to 25 total indents) between 500 $\mu$N and 10.000 $\mu$N, yielding maximum displacements between 20 nm and 120 nm, depending on the sample, were recorded. All indents were used to evaluate the hardness and the reduced Young's modulus. Reduced Young's modulus values were corrected to include the tip contribution; therefore, Young's modulus values are presented. Uncoated Si and CC substrates were characterized by nanoindentation using 25 indents with 10 $\mu$m spacing and a load range of 500 $\mu$N to 10.000 $\mu$N, providing the following values for Si: H = 12 $\pm$ 0.7 GPa and E = 158 $\pm$ 7.3 GPa. The CC values were: H = 30 $\pm$ 2.4 GPa and E = 478 $\pm$ 19.8 GPa. Hardness and Young's modulus have been plotted as function of indendation depth, $h_c$ and the measured Young's modulus was affected before the measured hardness since the elastic zone under the indenter is much larger than the plastic zone. As a final check, two samples ($W_{90}Zr_2B_8$ deposited on Si and CC; see chapter 1.1) were prepared as cross-sections, enabling elastic modulus determination by nanoindendation without significant influence of the substrate. For these experiments, a calibrated cube-corner tip was used to first scan and image the sample surface in order to position the indents on the film cross section. Ten indents were made using a single load (2000 $\mu$N) and spaced 2 $\mu$m apart. Imaging after the indents were made was performed to ensure placement of the indents in the film cross-section. In both cases, the Oliver-Pharr method was used to calculate the hardness and reduced Young's modulus from the load-displacement curves.

### 1.5 Measurement of tribological properties of deposited WZrB thin films

The tribological properties of substrates coated with a WZrB thin film (see chapter 1.1) were measured using a CSM high temperature (HT) ball-on-disk tribometer. All tests were conducted using 6 mm $Al_2O_3$ balls as counter-bodies with a normal load of 5 N. The humidity meter (Voltcraft HT-200) was placed in the vicinity of the test sample. The tests were performed at RT (296 K), 573 and 973 K. In order to evaluate possible changes of the coatings during heating, two tests were done on each sample at different radii: first at RT (radius: 3 mm) and subsequently at HT, i.e. at 573 or 973 K (radius: 5 mm). To keep the number of cycles (2300) and the angular velocity ($\omega \approx 1.5$ rad/s) constant, the sliding distance and the linear velocity were adjusted when the wear track radius was changed. Similar tribological tests in ambient air were conducted in previous experiments and are described in A. Drnovšek, M. Rebelo de Figueiredo, H. Vo, A. Xia, S. Vachhani, S. Kolozsvári, P. Hosemann, R. Franz, Surface and Coatings Technology 372 (2019) 361-368. The wear tracks of the coatings was determined by a 3D confocal laser scanning microscope (Keyence VK-X1100) and the wear coefficient k was calculated as the ratio between the wear volume and the applied load times the number of cycles.

### 2. Results

The results of the tests performed on WZrB-thin-film-coated substrates (WZrB-TGFMs; see chapter 1.1 for method of manufacture) and according to the test methods described in chapter 1 are given in the following.

### 2.1 Chemical Composition and Structure

The thin film composition was set by varying the applied target power on the W target between 18 W and 200 W, while the power on the $ZrB_2$ target was kept constant at 71 W. EDX measurements of the films revealed a W fraction between 27 at% and 93 at%. Consequently, the Zr and B contents increases with decreasing W sputter power from between 3 at% to 40 at% and from 4 at% to 33 at%, respectively. When a pulsed DC power was applied on the W and $ZrB_2$ targets, the Zr content increased and the film composition changed from $W_{78}Zr_2B_{20}$ to $W_{82}Zr_{10}B_8$ and from $W_{72}Zr_4B_{24}$ to $W_{63}Zr_6B_{31}$. A similar increase of the Zr content was also obtained by igniting a third Zr target with a power of 18 W, where the Zr content in the thin film was increased and the TFMG composition changes from $W_{85}Zr_4B_{11}$ to $W_{80}Zr_{18}B_2$.

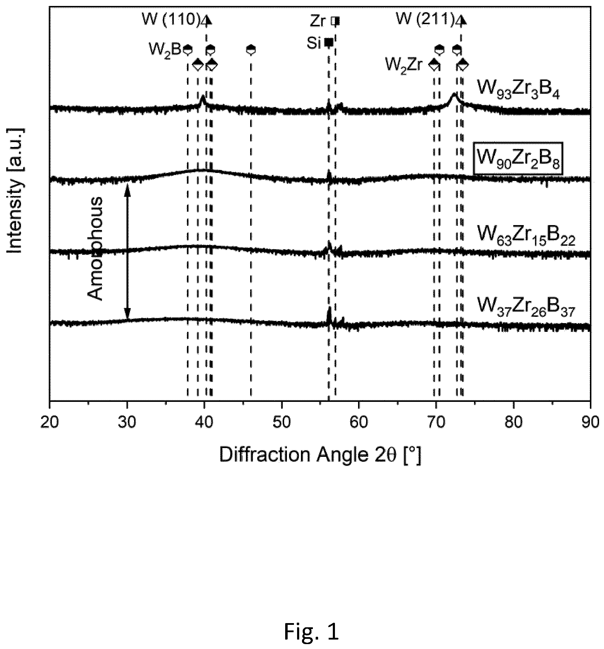

The change in the chemical composition of the films results in a change of their structure, as displayed by the representative X-ray diffractograms in Fig. 1. They reveal a typical amorphous pattern with an amorphous broad peak between 30 and 45° and with crystalline reflections, for almost all samples, except those with very high W fractions of 92 and 93 at%. With increasing W content, the films containing 92 and 93 at% W become crystalline with a dominant (211) W peak next to a less intensive (110) W peak for the alloys containing 92 and 93 at% W. Further, peaks originating from the Si substrate are visible for all films.

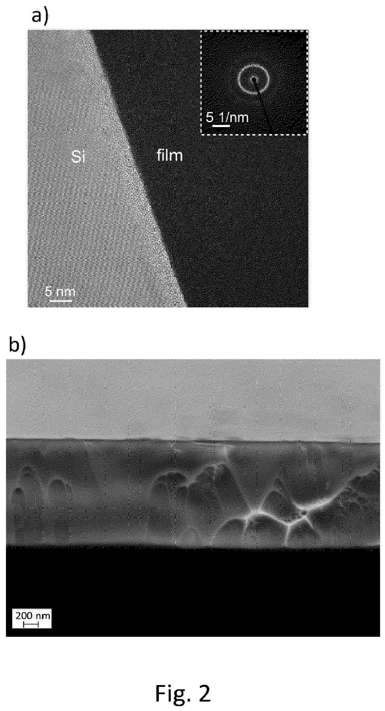

TEM investigations were carried out on $W_{90}Zr_2B_8$ thin films grown on Si to confirm the XRD results and to provide more detailed information about the film structure. Fig. 2a) depicts a typical high-resolution (HR)TEM image and the corresponding selected area electron diffraction (SAED) patterns of the prepared cross-sectional sample, revealing a fully amorphous structure without the presence of nanocrystals. Fig. 2b) displays the SEM cross-section of the $W_{90}Zr_2B_8$ film deposited on Si. The sample was broken by tensile stressed-induced fracturing, revealing a vein-like cross-section morphology which is typical for bulk metallic glasses (BMGs) and TFMGs.

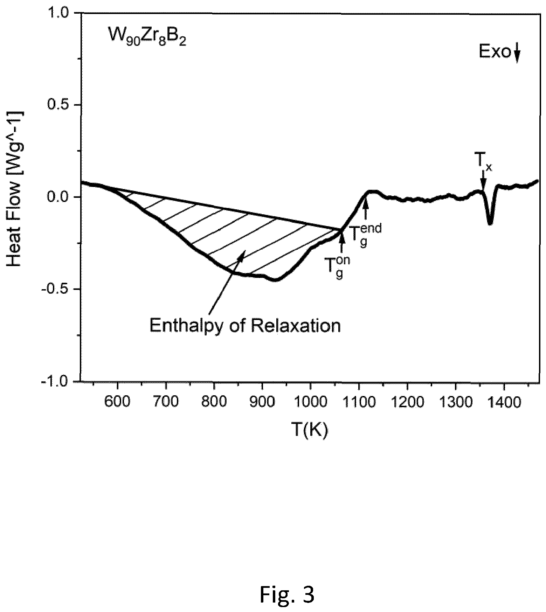

The DSC measurements depicted in Fig. 3 show the complete heat flow trace ranged from room temperature (RT) up to 1673 K. The onset ($T_g^{on}$) and end temperature ($T_g^{end}$) of the glass transition were measured at 1033 K and 1109 K, respectively. The crystallization temperature ($T_x$) was determined at 1358 K by intercepting the extrapolated tangent lines of the heat flow curves. The enthalpy of relaxation (shaded area) starts at around 573 K and extends up to $T_g^{on}$.

### 2.2 Mechanical Properties

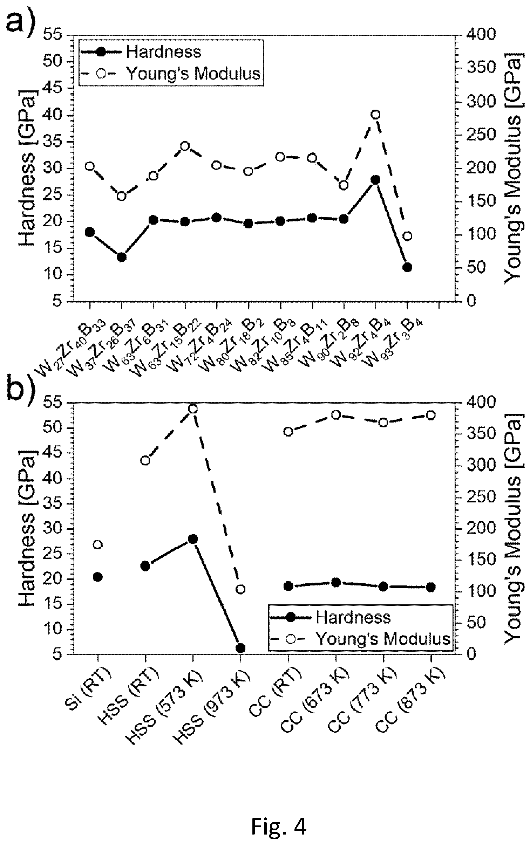

Average values for hardness and Young's modulus of the WZrB thin films on Si substrates as obtained by nanoindentation are depicted in Fig. 4a). Overall, the crystalline thin films with 92 at% W show the highest hardness and Young's modulus values of 27.8 ± 1 GPa and 281.1 ± 8 GPa, respectively. However, the crystalline samples with the highest W content of 93 at% W show the lowest hardness and Young's modulus values of 11.4 ± 0.1 GPa and 98.1 ± 3 GPa. The amorphous TFMGs, with W contents between 27 at% and 90 at% exhibit hardness values between 13.2 ± 0.2 GPa and 20.7 ± 0.5 GPa, while the Young's modulus was measured to be between 147.8 ± 2 GPa and 233.3 ± 2 GPa on Si substrates. The hardness values of as-deposited $W_{90}Zr_2B_8$ TFMGs on Si, HSS and CC substrate are between 18.6 ± 1 and 22.6 ± 1 GPa, depending on the underlying substrate. After tribotesting in ambient air and at elevated temperature of the TFMG on S600 substrate, the hardness and Young's modulus changes to 28 ± 0.5 GPa and 390.1 ± 9.5 GPa at 573 K and 6.3 ± 0.5 GPa and 103.4 ± 3.5 GPa at 973 K, respectively. The hardness value remains constant at 18.5 ± 0.5 GPa for the TFMGs deposited on CC, regardless of the vacuum annealing temperature up to 873K. The Young's modulus increases to around 300 GPa and 350 GPa for thin films on HSS and CC substrates, respectively, when measured by nanoindentation from the top surface.

An influence of the substrate on the Young's modulus cannot be completely excluded. In order to minimize the substrate effect, nanoindentation tests have been performed on the thin film cross section for TFMGs deposited on Si and CC substrates. The measured hardness and Young's modulus values of the film are on the order of 12 GPa and 155 GPa for the WZrB-TFMGs on Si substrate and around 13 GPa and 250 GPa for the WZrB-TFMGs on CC, respectively. The average hardness and Young's modulus of the pristine CC substrate was measured as 30.3 ± 2.5 GPa and 477.6 ± 20 GPa. The hardness and Young's modulus of (100) silicon at room temperature were reported to be about 13 GPa [L. J. Vandeperre, F. Giuliani, S. J. Lloyd, W. J. Clegg, Acta Materialia 55 (18) (2007) 6307-6315] and 180 GPa [B. Bhushan, X. Li, Journal of Materials Research 12 (01) (1997) 54-63], respectively. These values were confirmed by the inventors' measurements. The H/E ratio calculated from the data in Fig. 4 b) gives a value around 0.12 for the WZrB-TFMGs deposited on Si substrate while for as-deposited and ambient air annealed WZrB-TFMGs deposited on S600 and vacuum annealed WZrB-TFMGs on CC the H/E ratio was calculated to be between 0.05 and 0.08 for top surface nanoindentation.

### 2.3 Tribological Tests

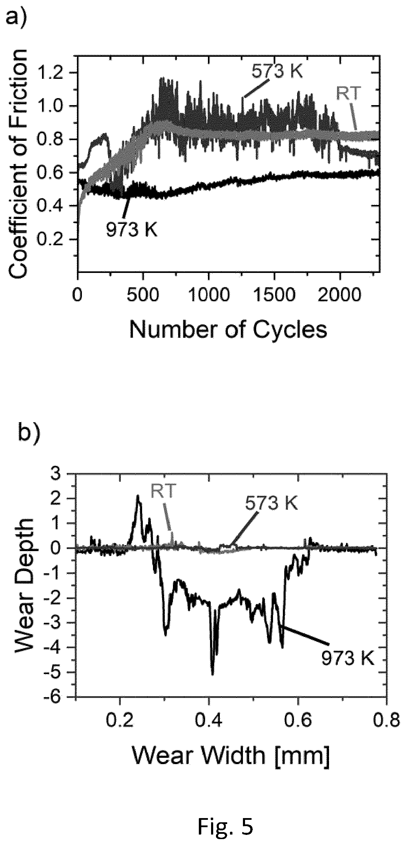

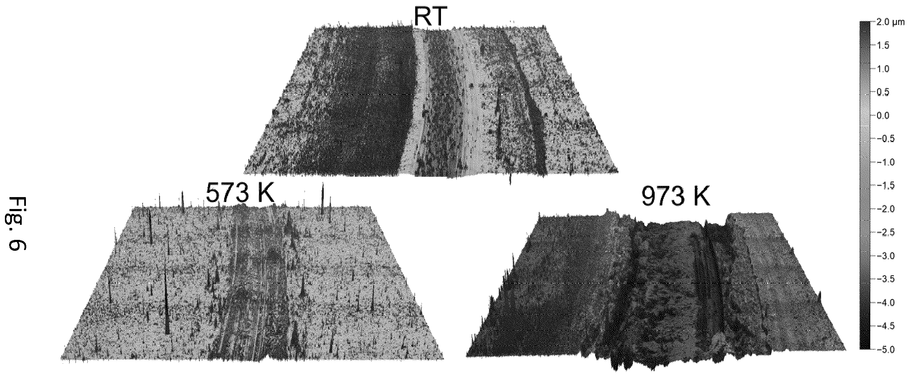

From the tribological tests against $Al_2O_3$ counterparts performed at RT and elevated temperatures, a correlation between the friction and abrasive wear behavior of the WZrB-coatings can be derived. Fig. 5a) shows the coefficient of friction (COF) depending on the number of cycles. At RT, the COF stabilizes at around 0.8 after a running-in period of approximately 750 cycles. At 573 K, the COF of the thin films slightly increases to a value around 0.9 with scattering after a similar running-in period of 750 cycles. The COF decreases to around 0.7 after 2000 cycles. At 973 K, the friction curve has no pronounced running-in period and exhibits a slight increase in the friction value from around 0.45 at 700 cycles to around 0.6 at 2300 cycles. The wear track profiles after testing are illustrated in Fig. 5b) and the 3D profiles of the wear tracks are presented in Fig. 6. After RT and 573 K tribotesting, no significant wear was observed for these experiments. However, at 973 K, grooves in the wear track center are visible, revealing the highest wear. The wear track depth at 973 K is already in the range of the coating thickness indicating a worn through coating. This results in an increased amount of wear debris in the contact, which can explain the observed decrease in COF in this temperature range. Similar high temperature tribological wear tests have been performed and observed in previous high temperature tribological tests on CrAl and CrAlSiN coatings [A. Drnovšek, M. Rebelo de Figueiredo, H. Vo, A. Xia, S. Vachhani, S. Kolozsvári, P. Hosemann, R. Franz, Surface and Coatings Technology 372 (2019) 361-368].

### 3. Discussion

The results of the tests (see chapter 2) performed on WZrB-thin-film-coated substrates (WZrB-TGFMs; see chapter 1.1 for method of manufacture) and according to the test methods described in chapter 1 are discussed in the following.

### 3.1 Influence of physical vapor deposition (PVD) method

Comparing the XRD patterns of the different thin film compositions indicates that the thin film structure is mainly influenced by the chemical composition and the cooling rate of the deposition technique. The transition from amorphous to crystalline state is mainly attributed to the higher amount of W in the specimens. Zr and B both act as strong glass forming elements in the thin films and stabilize the glassy state. A large atomic radius mismatch between Zr and B slows down the crystallization kinetics when quenching from the melt. As MSD enables extremely fast cooling rates of up to $10^{13}Ks^{-1}$ for all depositions, the film structure is mainly influenced by the atomic size differences, heat of mixing and amount of the constituent elements. Deposition with slightly increased W target power from 122 W to 125 W for the same deposition time indicate a higher W flux during sputtering. This results in the formation of crystalline phases, as revealed by the small crystalline peaks in the XRD patterns. This is mainly influenced by the chemical composition in the thin films, as the glass-forming ability is reduced by lowering the Zr and B contents and increasing the amount of W in the thin films. According to previous publications on the W-Zr binary systems and the inventors' own preliminary studies on WZr thin films, at least 20 at% Zr or B is needed in the thin film to ensure the formation of an amorphous structure [J. Bhattarai, E. Akiyama, H. Habazaki, A. Kawashima, K. Asami, K. Hashimoto, Corrosion Science 39 (2) (1997) 355-375]. By increasing the amount of the glass-forming element Zr and introducing B as the ternary element in the thin films, the glass-forming ability of the thin film system is increased to around 91 at% W content. By increasing the power on the W target in continuous DC mode, the W content increases on the expense of Zr and B in the film film. Once the $W/ZrB_2$ substrate power ratio reaches 1 or higher, the Zr content in the thin film stays constantly between 2 and 4 at%, while the B is continuously subsidized by W. This trend can be explained by the higher W flux during deposition resulting in the higher W content in the thin film. Further, a decrease in Zr and B may be affected by the redeposition of the lighter elements from the substrate surface. To counter this effect, the adaption of the deposition parameters show that Zr content in the thin film can be increased by pulsing both W and $ZrB_2$ targets or by introducing/igniting a third Zr target.

**3.2 Influence of the Glass Transition Temperature on the Mechanical Properties**

The differences in the film growth conditions exerted by MSD critically affect $T_g$ and, consequently, the mechanical properties of WZrB-TFMGs. Further, $T_g$ is influenced by the $T_m$ of the constituting elements. It has been reported, that at temperatures approaching the $T_g$, bulk metallic glasses (BMGs) undergo plastic flow, resulting in a substantial decrease in quasi-static strength. This results in pronounced softening, which is unsuitable for practical applications [M.-X. Li, S.-F. Zhao, Z. Lu, A. Hirata, P. Wen, H.-Y. Bai, M. Chen, J. Schroers, Y. Liu, W.-H. Wang, Nature 2019 569:7754 569 (7754) (2019) 99-103]. Incorporation of W ($T_m$ ~ 3695 K, Zr ($T_m$ ~ 2128 K) and B ($T_m$ ~ 2349 K) into the WZrB-TFMG composition increases the $T_g$ to 1109 K. Both, B and the low-modulus element Zr have been shown to enhance the glass-forming ability.

The transition from amorphous to crystalline state is mainly attributed to the higher amount of Zr and B, both acting as strong glass-forming elements in the thin films. Similar crystalline to-amorphous transition effects have been observed in previous studies of the binary W-Zr system [J. Bhattarai, E. Akiyama, H. Habazaki, A. Kawashima, K. Asami, K. Hashimoto, Corrosion Science 39 (2) (1997) 355-375; M. Cervená, R. Cerstvý, T. Dvorak, J. Rezek, P. Zeman, Journal of Alloys and Compounds 888]. Here, the inventors were able to extend the amorphous range up to 91 at% W by adding B as a second glass-forming element. The amorphous state of the WZrB-TFMGs at high W content is confirmed by the TEM images in Fig. 2a) and can be further illustrated by the fractographs of the cross section images depicted in Fig. 2b). The vein-like viscous fracture patterns including dimples, veins and droplets are typical fracture features of ductile MGs. This is explained by the shear bands formed during loading. The shear-softened nature of metallic glasses (MGs) allows multiple shear bands to propagate and delaminate from each other creating the viscous fracture pattern. These features indicate that $W_{90}Zr_2B_8$ TFMGs are ductile, as brittle MGs would form a smooth conchoidal fragment surface.

It has been reported that heat treatment in the glass transition temperature region influences the microstructure and mechanical properties of W-based BMGs [H.B. Yu, Y. Luo, K. Samwer, Advanced Materials 25 (41) (2013) 5904-5908]. The onset temperature of crystallization for as-quenched W-based MGs has been reported to range between 1043 K and 1273 K. The crystallization temperature of $W_{90}Zr_2B_8$ is higher than for conventional Zr-based MGs (typically around 748 °C). In the case of $W_{90}Zr_2B_8$ TFMGs, the higher W content in the thin films improves the thin film hardness, while Zr and B prevent a strong increase in the Young's modulus. Vacuum annealing tests in the transition temperature region (673 K, 773 K and 873 K) of $W_{90}Zr_2B_8$ TFMGs deposited on CC substrates show a stable hardness value (Fig. 4b). Earlier works on nanoindentation tests on IrNiTaB TFMGs have revealed a hardness of 15 GPa and a Young's modulus of 263 GPa on Si substrates at RT. These values were unprecedented for MGs [M.-X. Li, S.-F. Zhao, Z. Lu, A. Hirata, P. Wen, H.-Y. Bai, M. Chen, J. Schroers, Y. Liu, W.-H. Wang, Nature 2019 569:7754 569 (7754) (2019) 99-103] and are even slightly exceeded by the hardness and Young's modulus results for the present $W_{90}Zr_2B_8$ TFMGs on Si substrates, i.e. 20 GPa and 175 GPa, respectively. Structural relaxation affects the mechanical and other properties of MGs. This is interpreted in terms of free volume annihilation due to structural relaxation of the material. Annealing temperatures in the relaxation area usually lead to a decrease of defect concentration, with a corresponding increase of the shear modulus, thus affecting the hardness and Young's modulus values. Although, distinct relaxation is observed in the DSC curve of the free-standing film is measured, no annealing effects on the hardness and Young's modulus values were detected. This may be attributed to the release of stresses when the films are detached from the NaCl substrates and prepared for the subsequent DSC measurements.

**3.3 Tribology**

3D confocal laser scanning microscopy indicates that the dominating wear mechanism in the tests against $Al_2O_3$ balls is abrasion, while at elevated temperatures tribo-oxidation also plays a significant role for the wear of the WZrB-TFMGs. As a consequence, minimum wear against $Al_2O_3$ balls was obtained for the hardest coatings, i.e., a hardness of 22 GPa and 28 GPa after tribotesting at RT and 573 K.

At elevated temperatures, the wear rate can increase significantly depending on the hardness and Young's modulus. Besides high hardness after high temperature tribotesting, also oxidation resistance has a major impact. Although the maximum testing temperature was limited to 973 K, local temperatures during tribocontact can become considerably higher. The WZrB-TFMGs tribotested at 973 K show the highest wear rate (see Fig. 5 b) and a low hardness of 6 ± 0.5 GPa as measured after tribotesting. The wear track profile of the WZrB-TFMGs tested at 973 K shows that the coating is worn through. The spalled coating and the exposed substrate reacted with oxygen forming oxides, which act as a lubricant to decrease the COF. These results correspond well to earlier studies [A. Drnovšek, M. Rebelo de Figueiredo, H. Vo, A. Xia, S. Vachhani, S. Kolozsvári, P. Hosemann, R. Franz, Surface and Coatings Technology 372 (2019) 361-368; A. Reiter, V. Derflinger, B. Hanselmann, T. Bachmann, B. Sartory, Surface and Coatings Technology 200 (7) (2005) 2114-2122; A. E. Reiter, C. Mitterer, M. R. Figueiredo, R. Franz, Tribology Letters 37 (3) (2009) 605-611], where the tribological tests were carried out by $Al_2O_3$ ball-on-disk tests. The COF of the WZrB-TFMGs at 573 K remains almost unchanged at around 0.8, when compared to the COF at RT. At 573 K, the COF value for the WZrB-TFMGs is similar to the COF for diamond like carbon (DLC) at 573 K with the latter reported to be thermally stable only up to 573 K. The reason is the drastical hardness decrease due to graphitization of the DLC thin film structure [H. Ronkainen, K. Holmberg, Tribology of Diamond-Like Carbon Films: Fundamentals and Applications (2008) 155-200]. The thermal stability of the WZrB-TFMGs at 573 K without thin film oxidation demonstrates the usefulness and application of the WZrB-TFMGs at elevated temperature as a protective thin film.

The H/E ratio is generally used as an indicator for the wear resistance of a coating, and is calculated to be in the range of 0.05 and 0.13 for the WZrB TFMGs synthesized on different substrates. This correlates to the data for established TiN, CrAlN and TiAlN protective coatings, where H/E values between 0.03-0.09 are reported depending on the annealing temperature [A. Drnovšek, M. Rebelo de Figueiredo, H. Vo, A. Xia, S. Vachhani, S. Kolozsvári, P. Hosemann, R. Franz, Surface and Coatings Technology 372 (2019) 361-368; B. D. Beake, J. F. Smith, A. Gray, G. S. Fox-Rabinovich, S. C. Veldhuis, J. L. Endrino, Surface and Coatings Technology 201 (8) (2007) 4585-4593]. The hardness values obtained from the top surface are hardly affected by the substrate material, since the indentation depth is around 100 nm. The plastic zone is therefore confined within the thin film and the hardness value is used to calculate the H/E ratio. For the present studies, cross section nanoindentation experiments have also been performed on the WZrB-TFMG cross section deposited on CC in order to minimize substrate effects on the thin film due to the big elastic zone in WZrB-TFMGs. Therefore, nanoindentation on the WZrB-TFMG cross section may resemble Young's moduli with reduced substrate effect, although the thin film growth direction and cross section yielding caused during sample preparation may also contribute to the true Young's modulus value. The cross-sectional Young's modulus value for $W_{90}Zr_2B_8$ TFMG on CC after annealing at 673 K was measured to be around 248.7 ± 4 GPa compared to a Young's modulus value of 380.9 ± 6 GPa measured from the top surface nanoindentation. This results in a H/E ratio variation between 0.051 and 0.078 when comparing Young's modulus values from the top surface and cross section nanoindentation. Although the smaller Young's moduli from the cross section lead to higher H/E values, the inventors believe, but without being wished to be bound to a certain theory, that the higher top surface nanoindentation values may represent the minimal TFMG H/E ratio in a real application scenario. However, for tribological applications, not only super- or ultra-high hardness and low Young's modulus should be pursued but also a close Young's modulus value between substrate and thin film should be considered. The present results show that the H/E ratio remains constant for the magnetron sputtered WZrB-TFMGs on CC substrates with increasing vacuum annealing temperature.

## 4. Summary

In the present study, the inventors of the present invention were able to synthesize different compositions of a novel WZrB-TFMG by means of MSD (see chapters 1. - 3. above). The amorphous phase formation range of the thin film composition was extended up to 91 at% W by adding B as a second glass-forming element. $W_{90}Zr_2B_8$ was selected due to its amorphous microstructure, high hardness of 20 GPa and high $T_g$, indicating the formation of a stable amorphous phase that can be preserved up to 1013 K. The chosen composition was deposited on multiple industrially relevant substrates such as HSS and CC for tribological tests. The tribological tests revealed an oxidation and wear resistant thin film material with a COF similar to conventional ceramic protective coatings at RT and 573 K. The wear resistance is comparable to industrially relevant coatings such as TiN, CrAlN and TiAlN and may complement DLC during high temperature wear application.

In general, the obtained results demonstrate that the synthesized WZrB-TFMGs according to the invention, especially those with optimized structure, have excellent mechanical and tribological properties and, thus, are useful for many different applications, where components having a scratch-resistant coating are required. For example, the present invention is useful in providing scratch-resistant articles comprising such WZrB-coating described herein as cutting parts for machining tools, as components in microelectronic devices, sports articles, biomedical devices, vehicles, aircraft, ships, watch cases, watch parts, and microelectromechanical systems (MEMS), and as components of devices and systems for space technology. Thus, the present invention opens a wide range of applications, including applications in space technology requiring vacuum stability at low temperature environments. In addition, MSD allows the on-site fabrication of the thin film on the substrate during a space mining mission.

The foregoing examples and described embodiments have been set forth merely to illustrate the invention and are not intended to be limiting. Since modifications of the disclosed embodiments incorporating the substance of the invention may occur to those skilled in the art, the invention should be construed to include everything within the scope of the appended claims.

**Claims**

1. A scratch-resistant article comprising:

   a substrate, and an amorphous WZrB thin film deposited on the substrate by magnetron sputter deposition (MSD), wherein the amorphous WZrB thin film is defined by the following formula:

$$W_{(100-a-b-x)}Zr_aB_b$$

   with
   1 at% $\leq$ a $\leq$ 25 at%;
   1 at% $\leq$ b $\leq$ 35 at%;
   wherein 9 at% $\leq$ a + b $\leq$ 60 at%;
   and the balance being tungsten and unavoidable impurities x, wherein the unavoidable impurities x may be present in the amorphous WZrB thin film in an amount of up to 4 at%; wherein the amorphous WZrB thin film has a hardness **H** of 19 GPa or more, preferably of 20 GPa or more, and a Young's modulus **E** in a range from 150 GPa to 300 GPa, and the layer thickness of the amorphous WZrB thin film is in a range from 0.2 $\mu$m to 20.0 $\mu$m.

2. The scratch-resistant article according to claim 1, wherein the H/E-ratio is in a range from 0.05 to 0.13.

3. The scratch-resistant article according to claim 1 or 2, wherein

   1 at% $\leq$ a $\leq$ 18 at%;
   1 at% $\leq$ b $\leq$ 11 at%;
   9 at% $\leq$ a + b $\leq$ 21 at%;
   x $\leq$ 4 at%;
   wherein the amorphous WZrB thin film has a hardness **H** in a range from 20 GPa to 21 GPa and a Young's modulus **E** in a range from 175 GPa to 217 GPa, wherein the H/E ratio is in a range from 0.09 to 0.12.

4. The scratch-resistant article according to any one of claims 1 to 3, wherein

   1 at% $\leq$ a $\leq$ 3 at%;
   7 at% $\leq$ b $\leq$ 9 at%;
   9 at% $\leq$ a + b $\leq$ 11 at%;
   x $\leq$ 4 at%.

5. The scratch-resistant article according to any one of claims 1 to 4, wherein the amorphous WZrB thin film has a hardness **H** of 21 GPa and a Young's modulus **E** of 175 GPa, wherein the H/E ratio is 0.12.

6. The scratch-resistant article according to any one of claims 1 to 5, wherein the amorphous WZrB thin film has a surface roughness of < 0.1 $\mu$m.

7. The scratch-resistant article according to any one of claims 1 to 6, wherein the substrate is selected from the group consisting of semiconductors, NaCl, cemented carbides, glass, ceramics, polymers, steels and metallic alloys.

8. The scratch-resistant article according to any one of claims 1 to 7, further comprising at least one intermediate layer as an undercoat, which is deposited on the substrate, wherein the amorphous WZrB thin film is deposited on the intermediate layer.

9. The scratch-resistant article according to any one of claims 1 to 8, wherein the amorphous WZrB thin film has a residual crystallinity of at most 8 at%.

10. A method for producing scratch-resistant surfaces of articles, comprising the steps of:

(a) providing a substrate, in a sputtering apparatus, wherein the sputtering apparatus comprises a tungsten target and a Zr/B alloy target consisting of Zr and B in a mixing ratio Zr:B from 30:70 to 37:63 at%;
b) releasing sputtered particles using a magnetron sputter deposition (MSD) process under process gas atmosphere at a process pressure in the range from 0.3 Pa to 0.6 Pa and at a cooling rate of $10^{12}$ Ks$^{-1}$ to $10^{14}$ Ks$^{-1}$, at a power in the range of 0.22 to 2.50 W/cm$^2$ per target surface area of the tungsten target and a power in the range of 0.84 to 0.91 W/cm$^2$ per target surface area of the Zr/B alloy target, wherein the power ratio of the tungsten target: the Zr/B alloy target is ranging from 18:74 to 200:68;
c) controlling the magnetron sputter deposition (MSD) process such that amorphous WZrB is deposited as a thin film having a layer thickness in a range of 0.2 $\mu$m to 20.0 $\mu$m on the substrate.

11. The method according to claim 10, wherein the process pressure in the magnetron sputter deposition (MSD) process is about 0.4 Pa.

12. The method according to claim 10 or 11, wherein the sputtering apparatus further comprises a Zr target, wherein during steps b) and c) sputtered particles are released from the Zr target at a power in the range of 0.84 to 0.91 W/cm$^2$ per target surface area of the Zr target.

13. The method according to any one of claims 10 to 12, wherein, in the magnetron sputter deposition (MSD) process, pulsing is applied on the tungsten target and the Zr/B alloy target in an asymmetric bipolar mode at a frequency set at 50 KHz and a reverse time set at 0.5 $\mu$s.

14. A scratch-resistant article produced by a method according to any one of claims 10 to 13.

15. Use of a scratch-resistant article according to any one of claims 1 to 9 and 14, as cutting parts for machining tools, as components in microelectronic devices, sports articles, biomedical devices, vehicles, aircraft, ships, watch cases, watch parts, and microelectromechanical systems (MEMS), as components of devices and systems for space technology, and as a primed base support for a protective coating, wherein the WZrB thin film separates the protective coating from the substrate and acts as an adhesive buffer layer for the protective coating.

Fig. 1

a)

b)

Fig. 2

Fig. 3

Fig. 4

a)

b)

Fig. 5

Fig. 6

Europäisches
Patentamt

European
Patent Office

Office européen
des brevets

**EUROPEAN SEARCH REPORT**

Application Number

EP 22 18 7450

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | MARCIN MA\'ZDZIARZ ET AL: "Effect of zirconium doping on mechanical properties of W_1-xZr_xB_2 on the base of ab initio calculations and magnetron sputtered films", ARXIV.ORG, CORNELL UNIVERSITY LIBRARY, 201 OLIN LIBRARY CORNELL UNIVERSITY ITHACA, NY 14853, 25 March 2022 (2022-03-25), XP091184922, * pages 1,7,9,10 * | 1-15 | INV. C23C14/14 C23C14/34 C23C14/35 C23C14/54 C23C30/00 |
| A | PSIUK RAFAL ET AL: "Improved mechanical properties of W-Zr-B coatings deposited by hybrid RF magnetron - PLD method", APPLIED SURFACE SCIENCE, ELSEVIER, AMSTERDAM , NL, vol. 570, 9 September 2021 (2021-09-09), XP086810374, ISSN: 0169-4332, DOI: 10.1016/J.APSUSC.2021.151239 [retrieved on 2021-09-09] * page 2, paragraph 2 - pages 5-6, paragraph 3.1 * * page 8, paragraph 3.1 - page 10, paragraph 4 * | 1-15 | |
| A | DUBEY P ET AL: "Study on thermal stability and mechanical properties of nanocomposite Zr-W-B-N thin films", SURFACE AND COATINGS TECHNOLOGY, vol. 284, 1 January 2015 (2015-01-01), pages 173-181, XP029344360, ISSN: 0257-8972, DOI: 10.1016/J.SURFCOAT.2015.07.076 * page 174, paragraphs 2.1,3.1.1 * | 1-15 | |
| A | US 2020/325561 A1 (KANER RICHARD B [US] ET AL) 15 October 2020 (2020-10-15) * claim 1 * | 1-15 | |

TECHNICAL FIELDS
SEARCHED (IPC)

C23C

The present search report has been drawn up for all claims

| Place of search | Date of completion of the search | Examiner |
|---|---|---|
| The Hague | 25 January 2023 | Boussard, Nadège |

EPO FORM 1503 03.82 (P04C01)

**EP 4 311 864 A1**

## ANNEX TO THE EUROPEAN SEARCH REPORT
## ON EUROPEAN PATENT APPLICATION NO.

EP 22 18 7450

This annex lists the patent family members relating to the patent documents cited in the above-mentioned European search report.
The members are as contained in the European Patent Office EDP file on
The European Patent Office is in no way liable for these particulars which are merely given for the purpose of information.

25-01-2023

| Patent document cited in search report | | Publication date | Patent family member(s) | Publication date |
|---|---|---|---|---|
| US 2020325561 A1 | | 15-10-2020 | BR 112013027189 A2 | 27-12-2016 |
| | | | EP 2699703 A2 | 26-02-2014 |
| | | | ES 2655245 T3 | 19-02-2018 |
| | | | US 2014041313 A1 | 13-02-2014 |
| | | | US 2019017154 A1 | 17-01-2019 |
| | | | US 2020325561 A1 | 15-10-2020 |
| | | | WO 2013022503 A2 | 14-02-2013 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **A. DRNOVŠEK ; M. REBELO DE FIGUEIREDO ; H. VO ; A. XIA ; S. VACHHANI ; S. KOLOZSVÁRI ; P. HOSEMANN ; R. FRANZ.** *Surface and Coatings Technology,* 2019, vol. 372, 361-368
- **L. J. VANDEPERRE ; F. GIULIANI ; S. J. LLOYD ; W. J. CLEGG.** *Acta Materialia,* 2007, vol. 55 (18), 6307-6315
- **B. BHUSHAN ; X. LI.** *Journal of Materials Research,* 1997, vol. 12 (01), 54-63
- **J. BHATTARAI ; E. AKIYAMA ; H. HABAZAKI ; A. KAWASHIMA ; K. ASAMI ; K. HASHIMOTO.** *Corrosion Science,* 1997, vol. 39 (2), 355-375
- **M.-X. LI ; S.-F. ZHAO ; Z. LU ; A. HIRATA ; P. WEN ; H.-Y. BAI ; M. CHEN ; J. SCHROERS ; Y. LIU ; W.-H. WANG.** *Nature,* 2019, vol. 569 (7754), 7754-569, 99-103
- **M. CERVENÁ ; R. CERSTVÝ ; T. DVORAK ; J. REZEK ; P. ZEMAN.** *Journal of Alloys and Compounds,* 888
- **H.B. YU ; Y. LUO ; K. SAMWER.** *Advanced Materials,* 2013, vol. 25 (41), 5904-5908
- **A. REITER ; V. DERFLINGER ; B. HANSELMANN ; T. BACHMANN ; B. SARTORY.** *Surface and Coatings Technology,* 2005, vol. 200 (7), 2114-2122
- **A. E. REITER ; C. MITTERER ; M. R. FIGUEIREDO ; R. FRANZ.** *Tribology Letters,* 2009, vol. 37 (3), 605-611
- **H. RONKAINEN ; K. HOLMBERG.** *Tribology of Diamond-Like Carbon Films: Fundamentals and Applications,* 2008, 155-200
- **B. D. BEAKE ; J. F. SMITH ; A. GRAY ; G. S. FOX-RABINOVICH ; S. C. VELDHUIS ; J. L. ENDRINO.** *Surface and Coatings Technology,* 2007, vol. 201 (8), 4585-4593